# EUROPÄISCHE PATENTSCHRIFT

(11) **EP 1 255 299 B1**
(45) Veröffentlichungstag und Bekanntmachung des Hinweises auf die Patenterteilung: **09.01.2008**
(21) Anmeldenummer: 02008374.7
(22) Anmeldetag: 12.04.2002
(51) Int. Cl.: H01L 23/48, H01L 23/051

(54) **Leistungshalbleitermodul in Druckkontaktierung**
Power semiconductor device with pressure contact
Module semiconducteur de puissance avec contact à pression

(30) Priorität: 05.05.2001 DE 10121970
(43) Veröffentlichungstag der Anmeldung: 06.11.2002
(73) Patentinhaber: SEMIKRON Elektronik GmbH & Co. KG, 90431 Nürnberg (DE)
(72) Erfinder: Heilbronner, Heinrich, Dr., 90547 Stein (DE)

(56) Entgegenhaltungen:
- US-A- 5 267 867
- US-A- 5 659 952
- US-A- 5 856 913

## Beschreibung

Die Erfindung beschreibt ein Leistungshalbleitermodul mit aktiven und / oder passiven Bauelementen, insbesondere ein Stromumrichtermodul nach dem Oberbegriff des Anspruches 1. Derartige Leistungshalbleitermodule sind mehrfach aus der Literatur bekannt. Bei der Erhöhung der Leistungsfähigkeit, der Zuverlässigkeit sowie der Lebensdauer bei gleichzeitig verringerten Herstellungskosten sind veränderte Methoden der Aufbautechnologien für die einzelnen Bestandteile eine zwingende Voraussetzung.

Moderne Leistungshalbleitermodule, die Ausgangspunkt dieser Erfindung sind, sind grundplattenlose Module, wie beispielhaft in der DE 199 03 875 A1 beschrieben, bestehend aus
- einem Gehäuse;
- einem keramischen Substrat mit darauf angeordneten schaltungsgerecht ausgeführten metallischen Kaschierungen, wie sie z.B. nach dem DCB- (direct copper bonding) Verfahren hergestellt werden;
- auf diesem Substrat mittels Löttechnik stoffschlüssig aufgebrachten Bauelementen, wie beispielhaft Dioden, Transistoren, Widerständen oder Sensoren;
- Bondverbindungen zur Verbindung der strukturierten Seite der Bauelemente mit weiteren Bauelementen, dem Substrat und / oder nach außen führenden Anschlusselementen.
- Einer vorzugsweise aus Silikonkautschuk bestehenden Vergussmasse zur Isolation der einzelnen Bauelemente zueinander.

Sehr vorteilhaft hat sich für derartige Leistungshalbleitermodule die Aufbautechnologie mit Druckkontakt zur thermischen Kontaktierung des Moduls auf einem Kühlkörper erwiesen. Es hat sich gezeigt, dass sich insbesondere großflächige Lötverbindungen nur sehr schwer qualitätsgerecht beherrschen lassen, worunter die Zuverlässigkeit sowie die Lebensdauer der Leistungshalbleitermodule leiden.

Der Druckaufbau in derartigen druckkontaktierten Leistungshalbleitermodulen wird mittels einer mechanisch stabilen Druckplatte erzielt. Je nach weiterer Ausgestaltung kann der erzeugte Druck direkt mittels spezieller Ausgestaltungen der Druckplatte, wie beispielhaft in der DE 196 48 562 C1 gezeigt, oder mittels eines elastischen Druckspeichers nach der DE 199 03 875 A1, auf das Substrat übertragen werden.

Aus der DE 41 32 947 A1 sind flexible Leiterplatten sowie der Einsatz von elektrisch leitenden und / oder isolierenden Pasten in Leistungshalbleitermodulen bekannt. Diese werden als Ersatz für die keramischen Substrate sowie zur Verbindung zwischen den Bauelementen eingesetzt.

In der US 4,180,828 wird die Verbindung eines Bauelements mit den Leiterbahnen eines Substrates über eine flexible Folie beschrieben. Der elektrische Kontakt zwischen der Folie und dem Bauelement bzw. zwischen der Folie und den Leiterbahnen wird über Löt- oder Klebeverbindungen hergestellt.

Den Herstellungsverfahren nach DE 196 48 562 C1 oder DE 199 03 875 A1 haftet der Nachteil an, dass, wie bei modernen Modulen üblich, eine Vielzahl von Bauelementen miteinander und / oder mit dem Substrat kontaktiert werden müssen. Bondtechnisch wird dies mittels einer Vielzahl einzelner Bondverbindungen realisiert. Üblich sind hier durchaus bis zu 10 Bondverbindungen pro Bauelement. Da diese Bondverbindungen seriell hergestellt werden, erfordert ihre Herstellung einen erheblichen Zeitaufwand und verursacht damit auch einen wesentlichen Kostenanteil an der Modulherstellung.

Das Herstellungsverfahren nach DE 41 32 947 A1 weist einen zum Teil äußerst komplexen Schichtaufbau sowie die weitere Verwendung von klassischen Lötverbindungen auf. Ein effizienter Aufbau von Leistungshalbleitermodulen ist somit nicht gewährleistet.

In der US 4,180,828 wird die flexible Folie mittels Löt- oder Klebetechnik auf das Bauelement bzw. auf die Leiterbahnen des Substrates aufgebracht. Die praktische Herstellung derartiger Lötverbindungen gestaltet sich schwierig, da der Wärmeeintrag durch die Folie besondere Techniken erfordert, um eine Beeinträchtigung und / oder Zerstörung der Folie zu vermeiden.

Die US 5,267,867 offenbart eine Anordnung aus einer Mehrzahl von integrierten Schaltungen (ICs), die auf einem gemeinsamen Kühlsubstrat angeordnet sind. Auf der hierzu abgewandten Oberfläche weisen diese ICs Kontaktwarzen auf, die mit Kontaktwarzen einer flexiblen, mehrer ICs verbindenden; Leiterplatte elektrisch leitend verbunden sind. Zum Erzielen einer Kontaktsicherheit dieser Anordnung sind die einzelnen ICs von einem Halterahmen umgeben.

Die US 5,856,913 beschreibt ein Leistungshalbleitermodul, bestehend aus einem keramischen Substrat mit darauf strukturiert angeordneten und elektrisch leitfähigen Kontaktflächen, mit angeordneten Leistungsbauelementen und einer Druckkontaktierung zu einer flexiblen Leiterplatte.

Die US 5,659,952 beschreibt eine Anordnung zur Ausgestaltung eines Leistungshalbleitermoduls, bestehend aus einem Substrat, angeordneten Leistungsbauelementen und mehreren flexiblen Isolationsschichten, zwischen welchen ein flexibler Isolationsstoff eingebracht ist, um die elektrisch leitfähigen Bauteile zu isolieren und gleichzeitig eine Wärmeabfuhr zu ermöglichen.

Die vorliegende Erfindung hat die Aufgabe ein Leistungshalbleitermodul vorzustellen, bei dem zumindest teilweise auf Bond- und / oder Lötverbindungen zwischen den einzelnen Halbleiterbauelementen bzw. zwischen Halbleiterbauelementen und verschiedenartigen Kontaktflächen, z.B. denen des Substrates, verzichtet werden kann, das mindestens zum Stand der Technik gleichwertige Qualität in Bezug auf Lebensdauer und Zuverlässigkeit aufweist sowie kostengünstig herstellbar ist. Eine zusätzliche Aufgabe besteht darin, die Isolation der einzelnen Bauelemente gegeneinander zu vereinfachen.

Die Aufgabe wird gelöst durch die Maßnahmen des kennzeichnenden Teils des Anspruchs 1 sowie die zusätzliche Aufgabe durch die Maßnahmen des kennzeichnenden Teils des Anspruchs 2 . Weitere vorteilhafte Ausgestaltungen sind in den Unteransprüchen genannt. Dabei soll im Folgenden unter einer Leiterplatte nicht nur eine im wesentlichen starre Konstruktion verstanden werden, sondern auch moderne flexible Entwicklungen, wie sie auch im Stand der Technik beschrieben sind. Diese werden weiterhin als "flexible Leiterplatten" bezeichnet und sind gekennzeichnet durch einen Aufbau der verschiedene zueinander sowie zur Oberfläche isolierte Leiterbahnen und zur Oberfläche nicht isolierte Kontaktflächen zur elektrischen Kontaktierung aufweist,

Bei der Herstellung kostengünstiger Leistungshalbleitermodule bei gleichzeitig hoher Zuverlässigkeit und Lebensdauer müssen besonders aufwändige Produktionsschritte durch einfachere und schneller zu realisierende Lösungen ersetzt werden. Einen besonderen Zeitaufwand verlangt die Bestückung der Leistungshalbleitermoduls mit den Halbleiterbauelementen und deren anschließende schaltungsgerechte Verdrahtung mittels Bondverbindungen.

Die erfinderische Ausgestaltung der schaltungsgerechten Verdrahtung erfolgt zumindest teilweise mittels einer flexiblen Leiterplatte anstelle der Bondverbindungen. Bondverbindungen werden seriell hergestellt, während die Verbindung mittels der flexiblen Leiterplatte nur einen einzigen, schnell durchzuführenden Arbeitsgang erfordert. Aufgrund der oben dargestellten Nachteile stoffschlüssiger Verbindungen speziell von Lötverbindungen wird deren Einsatz auf möglichst wenige Einsatzbereiche beschränkt. Es bieten sich zwei gleichwertige Alternativlösungen an.

Die Halbleiterbauelemente werden auf die Kontaktflächen des keramischen Substrates stoffschlüssig aufgebracht. Wobei diese Kontaktflächen des Substrates derart ausgestaltet sind, dass sie schaltungsgerechte Verbindungen zwischen den einzeln Halbleiterbauelementen realisieren. Die stoffschlüssige Verbindung kann beispielhaft durch Löten oder durch ein moderneres und zum Teil auch in sich flexible Verbindungen gestattendes Klebeverfahren durchgeführt werden. Die weitere schaltungsgerechte Verdrahtung der Halbleiterbauelemente zueinander und auch zu weiteren Kontaktflächen des Substrates wird mittels der flexiblen Leiterplatte realisiert. Diese Leiterplatte wird durch die Druckkontaktierung des Moduls stoffbündig mit den ersten Hauptflächen der Halbleiterbauelemente verbunden. Diese Druckkontaktierung besteht nach dem Stand der Technik aus einem druckspeichernden Element sowie einer Druck in das System einleitenden Druckplatte. Der zur Kontaktierung notwendige Druck wird erst durch die Verbindung des Leistungshalbleitermoduls mit dem Kühlkörper hergestellt. Somit wird die vollständige und zuverlässige elektrische Kontaktierung des Leistungshalbleitermodul gleichzeitig mit der thermischen Kontaktierung des Leistungshalbleitermodul auf dem Kühlkörper realisiert.

Als zweite erfinderische Variante bietet sich an, die Halbleiterbauelemente stoffschlüssig, vorteilhafterweise mittels eines Klebeverfahrens, auf der flexiblen Leiterplatte zu befestigen. Die schaltungsgerechten Verbindungen sowohl auf dem Substrat als auch in der flexiblen Leiterplatte werden analog zur ersten Ausgestaltung realisiert. Durch Aufbringen der mit den Halbleiterbauelementen versehenen flexiblen Leiterplatte auf das Substrat wird die vollständige schaltungsgerechte Verdrahtung des Leistungshalbleitermoduls hergestellt. Die vollständige Funktionsfähigkeit der Verdrahtung wird erst durch die oben beschriebene Druckkontaktierung einschließlich der thermisch leitenden Verbindung mit dem Kühlkörper erzielt.

Mischformen beider Lösungen können bei speziellen Anwendungsfällen vorteilhaft sein.

Beide Lösungen besitzen die gleiche vorteilhafte Eigenschaft, dass die Herstellung der stoffbündigen elektrisch leitenden Verbindungen durch die im Leistungshalbleitermodul bereits zur thermischen Kontaktierung auf dem Kühlkörper vorhandene Druckkontaktierung ebenfalls erfolgt.

Die flexible Leiterplatte kann weiterhin zumindest zur teilweisen Kontaktierung der externen Leistungs- und / oder der Steueranschlüsse dienen. Hier sind ebenfalls stoffbündige und / oder stoffschlüssige Anschlussvarianten denkbar. Bei einer stoffbündigen Variante kann ebenfalls die Druckkontaktierung des Leistungshalbleitermoduls für die dauerhafte Verbindung, d.h. einen dauerhaft sicheren Kontakt, sorgen.

Die erfinderische Ausgestaltung der Isolation der einzelnen Bauelemente gegeneinander erfolgt durch einen flexiblen Isolationsstoff. Dieser Isolationsstoff kann eine pastöse oder schaumartige Struktur aufweisen. Vorzugsweise wird der Isolationsstoff auf die ersten Hauptflächen sowie die Zwischenräume zwischen den Bauelementen aufgebracht.

Anschließend wird im weiteren Herstellungsprozess der erfinderischen Leistungshalbleitermodule die flexible Leiterplatte aufgebracht. Auf dieser Leiterplatte sind auf der der ersten Hauptfläche der Bauelemente zugewandten Seite Warzen derart angeordnet, dass eine schaltungsgerechte Verbindung sichergestellt ist. Durch die Druckbeaufschlagung verdrängen die Warzen an den Stellen, an denen eine Kontaktierung erforderlich ist, den Isolationsstoff. Überschüssiger Isolationsstoff wird durch geeignete Aussparungen aus dem Bereich zwischen dem mit Bauelementen bestückten Substrat und der flexiblen Leiterplatte herausgepresst. Somit wird mittels der Druckkontaktierung sichergestellt, dass einerseits ein sicherer elektrischer Kontakt zwischen den Bauelementen bzw. den Kontaktflächen des Substrates sowie der flexiblen Leiterplatte hergestellt wird, und andererseits der Zwischenraum zwischen dem mit Bauelementen bestückten Substrat und der flexiblen Leiterplatte vollständig mit isolierendem Material verfüllt ist. Dies sichert die Isolation zwischen den einzelnen Bauelementen.

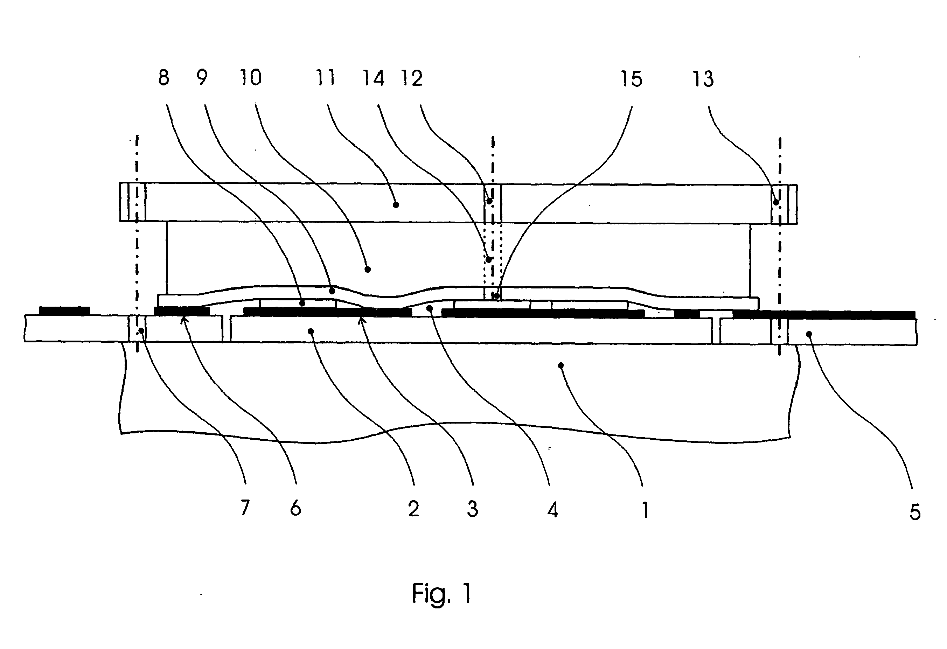

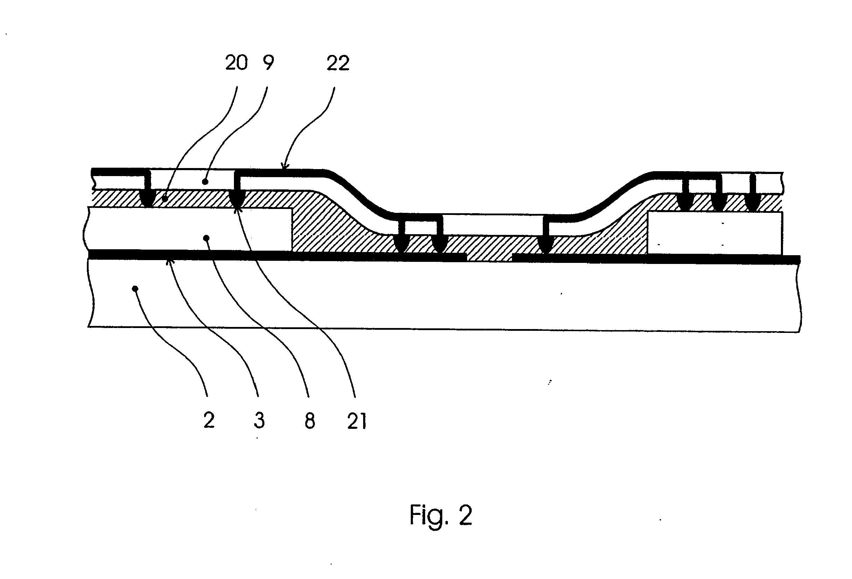

Spezielle Ausgestaltungen der erfinderischen Lösungen werden an Hand der Fig. 1 und 2 erläutert. Figur 2 zeigt dabei einen Detailausschnitt der Figur 1. Auf die Darstellung eines Gehäuses wird aus Gründen der Übersichtlichkeit verzichtet.

In den Figuren ist der Querschnitt durch ein die erfinderischen Merkmale aufweisendes Leistungshalbleitermodul in einem Aufbau mit einem Kühlkörper 1 gezeigt. Der Kühlkörper 1 ist thermisch leitend mit dem vorzugsweise keramischen Substrat 2 verbunden. Diese Verbindung mittels einer nicht dargestellten Wärmeleitpaste sowie einer ebenfalls nicht dargestellten flächigen Metallkaschierung der zweiten Hauptfläche des Substrates 2 hat sich nach dem Stand der Technik als hervorragend geeignet erwiesen, um die in Halbleitermodulen der Leistungsklasse entstehende Verlustwärme abzuführen.

Das gegenüber dem Kühlkörper 1 elektrisch isolierende keramische Substrat 2 weist auf seiner ersten Hauptfläche Kontaktflächen 3 auf, die als metallische Kaschierungen ausgebildet sind. Auf diesen Kontaktflächen 3 des Substrates 2 befinden sich die Halbleiterbauelemente 8. Die Kontaktflächen 3 sind derart gestaltet, dass eine schaltungsgerechte Verbindung der zweiten, dem Substrat zugewandten, Hauptflächen darauf zu platzierender Bauelemente 8 erfolgt.

In einer ersten Ausgestaltung der erfinderischen Lösung sind die Halbleiterbauelemente 8 stoffschlüssig mit den Kontaktierungen 3 verbunden. Diese stoffschlüssige Verbindung wird nach dem gegenwärtigen Stand der Technik vorzugsweise durch Löten hergestellt. Dabei werden Lötverfahren angewandt, die eine Lötung aller Halbleiterbauelemente 8 in einem Arbeitsgang erlauben. Die schaltungsgerechte Verbindung der jeweiligen ersten, der Keramik abgewandten Hauptflächen der Halbleiterbauelemente wird erfinderisch mittels einer flexiblen Leiterplatte 9 erreicht. Diese flexible Leiterplatte 9 wird nicht stoffschlüssig, sondern stoffbündig mit den ersten Hauptflächen der Halbleiterbauelemente verbunden. Eine dauerhafte sowie zuverlässige elektrische Kontaktierung wird erst nach der Druckkontaktierung des Gesamtaufbaus erreicht.

Die Kontaktflächen der flexiblen Leiterplatte 9 zur Kontaktierung mit den Halbleiterbauelementen 8 sollten bei dieser Ausgestaltung vorzugsweise warzenartige Erhebungen 21 aufweisen. Diese Warzen gewährleisten einerseits eine sichere Kontaktierung, andererseits kann damit eine effiziente Druckkontaktierung des gesamten Leistungshalbleitermoduls sicher gestellt werden.

Bei einer weiteren möglichen Ausgestaltung der erfinderischen Lösung werden die ersten Hauptflächen der Halbleiterbauelemente 8 stoffschlüssig mit der flexiblen Leiterplatte 9 verbunden. Diese Verbindung wird vorzugsweise mittels eines elektrisch leitfähigen Klebstoffes hergestellt. Eine löttechnisch Verbindung ist ebenfalls denkbar. Der Verbund aus flexibler Leiterplatte 9 und Halbleiterbauelementen 8 wird während des Herstellungsprozesses derart auf das Substrat 2 aufgebracht, dass die zweiten Hauptflächen der Halbleiterbauelemente derart auf den Kontaktflächen 3 des Substrates 2 zu liegen kommen, dass eine schaltungsgerechte Kontaktierung hergestellt wird. Die dauerhafte sowie zuverlässige elektrischen Kontaktierung mit den Kontaktflächen 3 des Substrates 2 wird ebenfalls erst nach der Druckkontaktierung im Gesamtaufbau erreicht.

Die bei Leistungshalbleitermodulen notwendige Kontaktierung von Leistungs- und Steueranschlüssen kann ebenfalls mittels der flexiblen Leiterplatte 9 realisiert werden. Dazu werden beispielhaft die extern herangeführten Anschlüsse auf mindestens einer starren oder auch flexiblen Leiterplatte 5 mit darauf befindlichen Kontaktierungen 6 direkt mittels der flexiblen Leiterplatte 9 stoffbündig mit den entsprechenden Anschlüssen des Leistungshalbleitermoduls mittels der im Leistungshalbleitermodul vorhandenen Druckkontaktierung verbunden. Die nicht notwendigerweise die gleiche Dicke wie das Substrat 2 aufweisenden externen Leiterplatten 5 sind zumindest teilweise mit ihrer zweiten Hauptfläche elektrisch isoliert auf dem Kühlkörper 1 plaziert. Die flexible Leiterplatte 9 überdeckt zum Zwecke der Kontaktierung der externen Leistungs- und Steueranschlüsse der Leiterplatte 5 derart, dass zumindest teilweise ein elektrischer Kontakt zwischen den entsprechenden Kontaktflächen der flexiblen Leiterplatte 9 sowie den Kontaktflächen 6 der externen Leiterplatte 5 besteht.

Alle stoffbündigen Kontakte werden erst nach Erstellen der Druckbeaufschlagung mittels eines elastischen Druckspeichers 10 und einer starren, Druck einleitenden Druckplatte 11, dauerhaft und zuverlässig geschlossen. Zur Druckeinleitung dient beispielhaft eine Schraubverbindung. Für diese Schraubverbindungen sind Durchführungen 7, 13, 14, 15 in der Druckplatte 11, wenn gefordert auch im Druckspeicher 10, dem Substrat 2 und / oder der externen Leiterplatten 5 vorzusehen. Somit werden bei der Montage auf einem Kühlkörper 1 gleichzeitig sowohl der thermisch leitende, elektrisch isolierende Kontakt des Leistungshalbleitermoduls zu diesem Kühlkörper 1 als auch alle elektrisch leitenden stoffbündigen Kontakte hergestellt.

Weiterhin können Durchführungen 12 vorgesehen werden, um weitere Leistungs- und / oder Steueranschlüsse mit der flexiblen Leiterplatte 9, den Halbleiterbauelementen 8 und / oder den Kontaktflächen 3 des Substrates 2 zu erlauben.

Die Hohlräume 4 zwischen dem Substrat 2 sowie er flexiblen Leiterplatte 9 können nach dem Stand der Technik zur Sicherung gegen elektrische Überschläge mit einem Dielektrikum, beispielsweise Silikonkautschuk, ausgefüllt sein.

Eine erfinderische Ausgestaltung der Isolation der einzelnen Bauelemente zueinander verwendet einen pastösen Isolationsstoff 20, der nach der Verbindung der Halbleiterbauelemente 8 mit den Kontaktflächen 3 des Substrates 2 flächig auf diesen Verbund aufgebracht wird. Die oberhalb dieses pastösen Isolationsstoffes platzierte flexible Leiterplatte 9 wird mittels der Druckkontaktierung bestehend aus der Druckplatte 11 sowie dem Druckspeicher 10 in Richtung des Substrates 2 gedrückt. Dabei verdrängen die Warzen 21 zur elektrisch Kontaktierung der flexiblen Leiterplatte 9 mit den Kontaktflächen der Halbleiterbauelemente 28 bzw. den Kontaktflächen 3 des Substrates 2 den in diesem Bereich befindlichen Isolationsstoff. Somit wird ein langzeitstabiler elektrischer Kontakt sichergestellt. Weiterhin wird durch die Druckkontaktierung der gesamte verbleibende Hohlraum zwischen der flexiblen Leiterplatte 9 sowie dem mit Halbleiterbauelementen 8 bestückten Substrat 2 vollständig oder wenn gefordert auch teilweise mit dem Isolationsstoff ausgefüllt. Überschüssiger Isolationsstoff wird durch geeignete Ausnehmungen oder an den Rändern des Leistungshalbleitermoduls verdrängt.

## Patentansprüche

1. Leistungshalbleitermodul bestehend aus einem Gehäuse, einem keramischen Substrat 2, schaltungsgerecht darauf angeordneten strukturierten und elektrisch leitenden Kontaktflächen 3, darauf angeordneten Bauelementen 8, die mittels einer zumindest teilweise oberhalb ihrer erster Hauptfläche angeordneten mit Leiterbahnen sowie Kontaktflächen versehenen flexiblen Leiterplatte 9 kontaktiert werden, wobei diese flexible Leiterplatte 9 die Bauelement 8 schaltungsgerecht miteinander und / oder mit den Kontaktflächen 3 des Substrates 2 verbindet und somit die schaltungsgerechte elektrische Verbindung des Moduls bildet und / oder die flexible Leiterplatte 9 die schaltungsgerechte Verbindung zu Kontaktflächen 6 mindestens einer externen Leiterplatte 5 bildet, sowie einer Druckkontaktierung bestehend aus einem flexiblen Druckspeicher 10 sowie einer den Druck erzeugenden Druckplatte 11 sowie Leistungs- und Steueranschlüssen
**dadurch gekennzeichnet, dass**
zur Isolation der Bauelemente 8 gegeneinander ein flexibler Isolationsstoff 20 eingebracht ist, sowie die Kontaktierung der flexiblen Leiterplatte 9 mit den Bauelementen 8 durch warzenartige Erhebungen 21 derart gebildet wird, dass bei Druckbeaufschlagung mittels der Druckkontaktierung eine sichere elektrisch leitende Verbindung gebildet wird.

2. Leistungshalbleitermodul nach Anspruch 1 **dadurch gekennzeichnet dass** mindestens ein Bauelementen 8 mit den Kontaktflächen 3 des Substrates 2 stoffschlüssig verbunden ist sowie mit mindestens einer Kontaktfläche der flexiblen Leiterplatte 9 mittels der Druckkontaktierung stoffbündig sowie elektrisch leitend verbunden ist.

3. Leistungshalbleitermodul nach Anspruch 1 **dadurch gekennzeichnet dass** mindestens ein Bauelementen 8 mit mindestens einer Kontaktfläche der flexiblen Leiterplatte 9 stoffschlüssig sowie elektrisch leitend verbunden ist sowie mittels der Druckkontaktierung stoffbündig mit mindestens einer Kontaktfläche 3 des Substrates 2 verbunden ist.

4. Leistungshalbleitermodul nach Anspruch 1 **dadurch gekennzeichnet, dass**
die Bauelemente 8 Leistungsdioden, Leistungsthyristoren, Leistungstransistoren Sensoren, Widerstände und / oder integrierte Schaltungen sind.

5. Leistungshalbleitermodul nach Anspruch 2 oder 3 **dadurch gekennzeichnet, dass**
der stoffschlüssige Kontakt durch Löten gebildet wird.

6. Leistungshalbleitermodul nach Anspruch 2 oder 3 **dadurch gekennzeichnet, dass**
der stoffschlüssige Kontakt durch eine Klebeverbindung mittels eines elektrisch leitfähigen Klebstoffes gebildet wird.

7. Leistungshalbleitermodul nach Anspruch 1 **dadurch gekennzeichnet, dass**
die flexiblen Leiterplatte 9 zumindest teilweise den Kontakt der Leistungs- und / oder Steueranschlüsse des Leistungshalbleitermoduls zu Kontaktflächen 6 mindestens einer externen Leiterplatte 5 bildet.

8. Leistungshalbleitermodul nach Anspruch 7 **dadurch gekennzeichnet, dass**
die Kontaktierung 6 der Leistungs- und / oder Steueranschlüsse zumindest teilweise stoffschlüssig mittels Löten oder Kleben gebildet wird.

9. Leistungshalbleitermodul nach Anspruch 7 **dadurch gekennzeichnet, dass**
die Kontaktierung 6 der Leistungs- und / oder Steueranschlüsse zumindest teilweise stoffbündig mittels der Druckkontaktierung gebildet wird.

## Claims

1. A power semiconductor device consisting of a housing, a ceramic substrate 2, structured and electro-conductive contact surfaces 3 disposed thereon in keeping with the circuitry, components 8 disposed thereon, which are in contact by means of a flexible circuit board 9 disposed at least in part above its first main surface provided with conductor paths and contact surfaces, wherein this flexible circuit board 9 connects the components 8 to one another in keeping with the circuitry and/or to the contact surfaces 3 of the substrate 2 and thereby forms the device's electrical connection in keeping with the circuitry and/or the flexible circuit board 9 forms the connection in keeping with the circuitry to contact surfaces 6 of at least one external circuit board 5, and also a pressure contact consisting of a flexible pressure reservoir 10 and a pressure plate 11 generating the pressure and also power and control connections,
**characterised in that**
in order to insulate the components 8 in relation to one another, a flexible insulating material 20 is incorporated and the contact of the flexible circuit board 9 to the components 8 is created by stud-like projections 21, such that a safe electro-conductive connection is made during pressurisation by means of the pressure contact.

2. The power semiconductor device according to claim 1, **characterised in that** at least one component 8 is connected to the contact surfaces 3 of the substrate 2 in a firmly bonded manner and is also connected to at least one contact surface of the flexible circuit board 9 in a firmly bonded and electro-conductive manner by means of the pressure contact.

3. The power semiconductor device according to claim 1, **characterised in that** at least one component 8 is connected to at least one contact surface of the flexible circuit board 9 in a firmly bonded and electro-conductive manner and is also connected to at least one contact surface 3 of the substrate 2 in a firmly bonded manner by means of the pressure contact.

4. The power semiconductor device according to claim 1, **characterised in that** the components 8 are power diodes, power thyristors, power transistors, sensors, resistors and/or integrated circuits.

5. The power semiconductor device according to claim 2 or 3, **characterised in that** the firmly bonded contact is created by soldering.

6. The power semiconductor device according to claim 2 or 3, **characterised in that** the firmly bonded contact is formed by an adhesive joint produced using an electro-conductive adhesive.

7. The power semiconductor device according to claim 1, **characterised in that** the flexible circuit board 9 forms at least in part the contact of the power and/or control connections of the power semiconductor device to contact surfaces 6 of least one external circuit board 5.

8. The power semiconductor device according to claim 7, **characterised in that** the contact 6 of the power and/or control connections is formed at least in part in a firmly bonded manner by soldering or adhesion.

9. The power semiconductor device according to claim 7, **characterised in that** the contact 6 of the power and/or control connections is formed at least in part in a firmly bonded manner by pressure contact.

## Revendications

1. Module semi-conducteur de puissance constitué d'un boîtier, d'un substrat céramique 2, de surfaces de contact 3 électriquement conductrices et structurées disposées sur le substrat de manière conforme au circuit, de composants 8 qui sont disposés dessus et qui sont mis en contact au moyen d'une carte flexible de circuits imprimés 9 qui est disposée au moins partiellement au-dessus de la première surface principale desdits composants et qui est munie de pistes conductrices et de surfaces de contact, cette carte flexible de circuits imprimés 9 reliant de manière conforme au circuit les composants 8 entre eux et/ou aux surfaces de contact 3 du substrat 2 et formant ainsi la liaison électrique du module conforme au circuit et/ou la carte flexible de circuits imprimés 9 formant la liaison conforme au circuit vers des surfaces de contact 6 d'au moins une carte externe de circuits imprimés 5, d'un contact par pression constitué d'un accumulateur de pression flexible 10 ainsi que d'une plaque de pression 11 produisant la pression et de bornes de puissance et de commande,
**caractérisé par le fait que**,
pour isoler les composants 8 les uns des autres, un matériau isolant flexible 20 est ajouté et le contact de la carte flexible de circuits imprimés 9 avec les composants 8 est formé de telle sorte par des bosses du type nodules 21 que, lors de l'application d'une pression, une liaison électriquement conductrice sûre est formée au moyen du contact par pression.

2. Module semi-conducteur de puissance selon la revendication 1, **caractérisé par le fait qu'**au moins un composant 8 est relié par liaison de matière aux surfaces de contact 3 du substrat 2 et est relié par affleurement de matière et de façon électriquement conductrice à au moins une surface de contact de la carte flexible de circuits imprimés 9 au moyen du contact par pression.

3. Module semi-conducteur de puissance selon la revendication 1, **caractérisé par le fait qu'**au moins un composant 8 est relié par liaison de matière et de façon électriquement conductrice à au moins une surface de contact de la carte flexible de circuits imprimés 9 et est relié par affleurement de matière à au moins une surface de contact 3 du substrat 2 au moyen du contact par pression.

4. Module semi-conducteur de puissance selon la revendication 1, **caractérisé par le fait que** les composants 8 sont des diodes de puissance, des thyristors de puissance, des transistors de puissance, des capteurs, des résistances et/ou des circuits intégrés.

5. Module semi-conducteur de puissance selon la revendication 2 ou 3, **caractérisé par le fait que** le contact par liaison de matière est formé par brasage.

6. Module semi-conducteur de puissance selon la revendication 2 ou 3, **caractérisé par le fait que** le contact par liaison de matière est formé par une liaison adhésive au moyen d'un adhésif électriquement conducteur.

7. Module semi-conducteur de puissance selon la revendication 1, **caractérisé par le fait que** la carte flexible de circuits imprimés 9 forme au moins en partie le contact des bornes de puissance et/ou de commande du module semi-conducteur de puissance vers des surfaces de contact 6 d'au moins une carte externe de circuits imprimés 5.

8. Module semi-conducteur de puissance selon la revendication 7, **caractérisé par le fait que** le contact 6 des bornes de puissance et/ou de commande est formé au moins en partie par liaison de matière au moyen d'un brasage ou d'un collage.

9. Module semi-conducteur de puissance selon la revendication 7, **caractérisé par le fait que** le contact 6 des bornes de puissance et/ou de commande est formé au moins en partie par affleurement de matière au moyen du contact par pression.
